# EUROPEAN PATENT SPECIFICATION

(11) **EP 3 148 298 B1**
(45) Date of publication and mention of the grant of the patent: **12.02.2020**
(21) Application number: 16168787.6
(22) Date of filing: 09.05.2016
(51) Int. Cl.: H05K 1/02, H05K 1/11, H05K 3/46, H05K 3/26, H05K 3/00

(54) **MANUFACTURING METHOD OF PRINTING CIRCUIT BOARD WITH MICRO-RADIATORS**
HERSTELLUNGSVERFAHREN ZUM DRUCKEN EINER LEITERPLATTE MIT MIKRO-RADIATOREN
PROCÉDÉ DE FABRICATION D'UNE CARTE DE CIRCUITS IMPRIMÉS AVEC MICRO-RADIATEURS

(30) Priority: 22.09.2015 US 201514861495
(43) Date of publication of application: 29.03.2017
(73) Proprietor: Rayben Technologies (HK) Limited, Shatin, NT (HK)
(72) Inventor: WU, Kai Chiu, Shatin, NT, Hong Kong (CN); RAYMOND, Lam Wai Kin, Shatin, NT, Hong Kong (CN); WANG, Zheng, Zhuhai Guangdong, 519180 (CN)
(74) Representative: Regimbeau

(56) References cited:
- EP-A1- 2 621 256
- CN-A- 101 790 290
- DE-A1- 10 234 995
- DE-A1- 10 258 090
- DE-A1-102013 204 889
- DE-U1-202014 006 215
- US-A1- 2008 179 618
- US-A1- 2014 144 677

## Description

### BACKGROUND OF THE INVENTION

Printed circuit boards (PCBs) are an important element in the electronics industry. PCBs are used as mechanical support elements for electronic components, and realize electrical connection among the electronic components. In addition, graphics and numbers of the components can be printed on the PCBs, it is convenient for furnishing, checking or maintaining the components. PCBs are used in almost every electronic device, such as an electronic watch, calculator, computer, communication electronics device, military weapon systems, etc.

LED devices are often attached to PCBs and typically release a large quantity of heat during their operation. It is necessary for a PCB coupled to an LED device to have good heat dissipation properties.

CN Application No. 201010101569.9 discloses a printed circuit board with a copper radiator. The copper radiator described therein can export the heat produced by a heating element but heat expansion coefficient of the radiator is significantly different from that of the substrate of the printed circuit board.

CN Application No. 201180037321.3, U.S. Patent Application Publication No. 2002/0180062, and others disclose printed circuit boards having a ceramic radiator. The ceramic radiators described therein can export the heat produced by a heating element but heat expansion coefficient of the radiator is significantly different from that of the resin layer that functions as the insulating carrier of the printed circuit board. U.S. Patent Application Publication No. 2014/0144677 also discloses a printed circuit board with a radiator embedded in a substrate, in which the difference in heat expansion coefficient between the radiator and the substrate may lead to a disengagement of the radiator from the substrate. Therefore, a need exists for an improved PCB design.

### BRIEF SUMMARY OF THE INVENTION

A PCB according to one aspect of the disclosure includes a radiator, having an electrically insulated core and a first electrically conductive layer formed on a top and bottom surface of the electrically insulated core, a substrate having a second electrically conductive layer formed on a top and bottom surface of the substrate, a plurality of electrode bonding pads formed on the top surface of the PCB, each of the electrode bonding pads comprising a third electrically conductive layer extending from a surface of the second electrically conductive layer to a surface of the first electrically conductive layer, the plurality of electrode bonding pads also comprising a positive electrode bonding pad and a negative electrode bonding pad, and a fourth electrically conductive layer on the bottom surface of the printed circuit board, the fourth electrically conductive layer extending from a surface of the second electrically conductive layer to a surface of the first electrically conductive layer. The PCB may have a plurality of terminals on the bottom surface of the PCB and electrically connected to the electrode bonding pads, and a heat dissipater on the bottom surface coupled to the radiator and the substrate.

A flexible PCB can also include a second printed circuit board having a top surface and a bottom surface, a radiator, a substrate, a plurality of electrode bonding pads on the top surface, a plurality of terminals on the bottom surface each electrically connected to at least one of the plurality of electrode bonding pads, and a heat dissipater on the bottom surface coupled to the radiator and the substrate and the PCBs can be linked by a flexible member between the top and bottom surfaces of each of the PCBs. The PCBS may be separated by a distance but remain linked to one another by the flexible member. The substrate may include a semi-cured sheet between a plurality of resin plates.

A method of manufacturing a flexible PCB according to one aspect of the disclosure may include providing a plurality of radiators each having an electrically insulated core and a first electrically conductive layer formed on a top and bottom surface of the electrically insulated core. The method may also include providing a substrate including a plurality of through holes, a flexible member, and a second electrically conductive layer formed on a top and bottom surface of the substrate, inserting the plurality of radiators in the plurality of through holes, and heat pressing the substrate and radiators to secure the substrate and radiators to each other. The method may further include depositing a third electrically conductive layer on the top surface of the flexible printed circuit board, depositing a fourth electrically conductive layer on the bottom surface of the flexible printed circuit board, each of the third and fourth electrically conductive layers extending from a surface of the second electrically conductive layer to a surface of the first electrically conductive layer, and removing a portion of the substrate between the radiators to create a flexible region.

The method could include coupling a resin plate having a plurality of through holes extending therethrough and a plurality of recesses extending partially through the resin plate to a semi-cured sheet having a plurality of through holes and a clearance hole, and to a flexible member together such that the plurality of through holes align and each of the plurality of recesses align with an edge of the clearance hole. Excess resin that flows to the surface of the flexible PCB may be removed from the surface of the flexible PCB. A plurality of electrode bonding pads and a heat conducting pad could be formed on the top surface of the flexible printed circuit board according to one method of the disclosure. The method could also include forming a plurality of terminals and a heat dissipating pattern on the bottom surface of the flexible printed circuit board, in which the heat dissipating pattern covers at least a portion of one of the plurality of radiators and the substrate. An LED may be coupled to the flexible PCB.

One aspect of the disclosure describes a method of manufacturing a PCB including forming a first electrically conductive layer on a top and a bottom surface of an electrically insulated core and etching a region of the first conductive layer to expose the insulated core. The insulated core can then be cut along the etched region to create a radiator which may have a portion of the insulated core remaining exposed after cutting. The method of manufacture can also include providing a substrate having a through hole and a second electrically conductive layer formed in a top and a bottom surface of the substrate, inserting the radiator into the through hole, heat pressing the radiator and the substrate, forming a third electrically conductive layer on the top surface of the printed circuit board, forming a fourth electrically conductive layer on the bottom surface of the printed circuit board, each of the third and fourth electrically conductive layers extending from a surface of the second electrically conductive layer to a surface of the first electrically conductive layer, and creating a plurality of electrode bonding pads and a heat conducting pad on the top surface of the printed circuit board.

The method may also include forming the second electrically conductive layer on a second surface of the radiator and substrate and etching the second conductive layer to form a plurality of terminals and a heat dissipating pattern. The substrate may include a semi-cured sheet and a resin plate having a fifth conductive layer and a sixth conductive layer, the fifth conductive layer having a circuit pattern and providing the substrate may include coupling the fifth conductive layer to the semi-cured conductive sheet such that the circuit pattern is internally contained within the substrate. An LED may be coupled to the plurality of electrode bonding pads.

### BRIEF DESCRIPTION OF THE DRAWINGS

A more complete appreciation of the subject matter of the present invention and the various advantages thereof can be realized by reference to the following detailed description, in which reference is made to the accompanying drawings:
Fig. 1A is a cross-sectional view of a radiator in accordance with one embodiment of the current invention.
Fig. 1B is a cross-sectional view of a resin plate in accordance with one embodiment of the current invention.
Fig. 1C is a cross-sectional view of a semi-cured sheet in accordance with one embodiment of the current invention.
Fig. 2 is a cross-sectional view of a PCB in accordance with one embodiment of the current invention including the radiator of Fig. 1A, the resin plate of Fig. 1B, and the semi-cured sheet of Fig. 1C.
Fig. 3 is a cross-sectional view of the PCB of Fig. 2 with excess resin.
Fig. 4 is a cross-sectional view of the PCB of Fig. 3 with the excess resin removed.
Fig. 5 is a cross-sectional view of the PCB of Fig. 4 with through holes formed therein.
Fig. 6 is a cross-sectional view of the PCB of Fig. 5 with a conductive layer formed thereon.
Fig. 7A is a cross-sectional view of the PCB of Fig. 6 with surface circuits formed on the conductive layers in accordance with one embodiment of the current invention.
Fig. 7B is a top view of the PCB of Fig. 7A.
Fig. 7C is a bottom view of the PCB of Fig. 7A.
Fig. 7D is a cross-sectional view of the PCB of Fig. 7A with an LED attached thereto.
Fig. 7E is a top view of a through hole in the PCB of Fig 7A.
Fig. 8A is a cross-sectional view of the PCB of Fig. 6 with surface circuits formed on the conductive layers in accordance with another embodiment of the current invention.
Fig. 8B is a cross-sectional view of the PCB of Fig. 8A with LEDs attached thereto.
Fig. 9A is a cross-sectional view of the PCB of Fig. 6 with surface circuits formed on the conductive layers in accordance with yet another embodiment of the current invention.
Fig. 9B is a cross-sectional view of the PCB of Fig. 9B with an LED attached thereto.
Fig. 10 is a cross-sectional view of a radiator in accordance with another embodiment of the current invention.
Fig. 11 is a cross-sectional view of a PCB in accordance with another embodiment of the current invention.
Fig. 12 is a cross-sectional view of a resin plate in accordance with yet another embodiment of the current invention.
Fig. 13 is a cross-sectional view of a PCB in accordance with another embodiment of the current invention.
Fig. 14 is a cross-sectional view of the PCB of Fig. 14 with portions of the resin plate removed.
Fig. 15 is flow chart illustrating one method of manufacturing a PCB in accordance with the current invention.
Fig. 16 is a cross-sectional view of the PCB of Fig. 2 between a heat pressing plate in accordance with one embodiment of the current invention.
Fig. 17 is a cross-sectional view of the PCB of Fig. 2 between of a heat pressing plate in accordance with another embodiment of the current invention.

### DETAILED DESCRIPTION

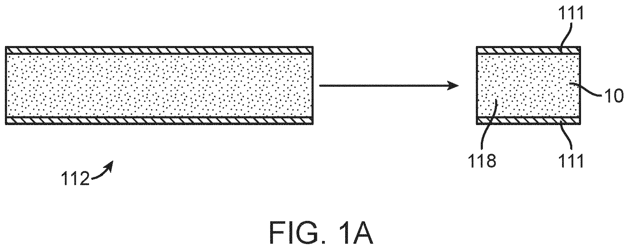

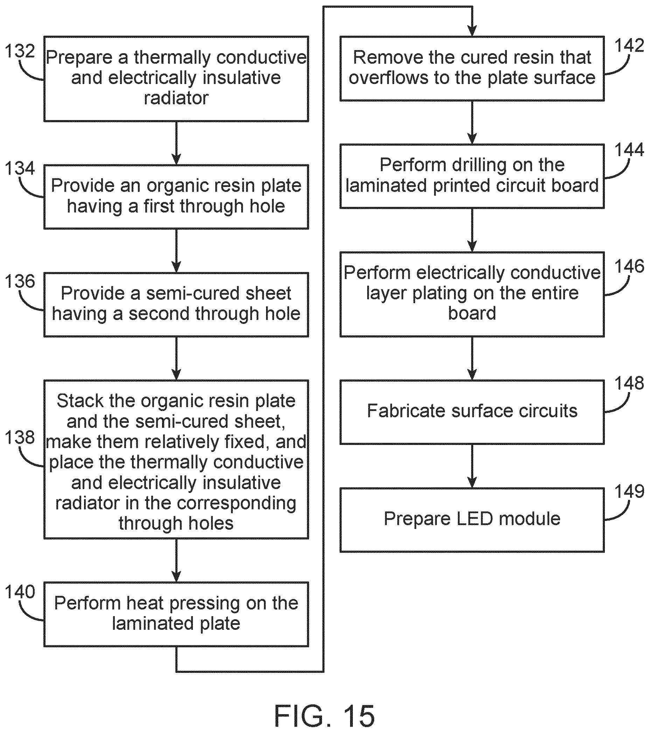

A method of manufacturing a PCB according to one embodiment of the invention includes preparing a thermally conductive and electrically insulative radiator as depicted in step 132 of Fig. 15. The preparation includes coating the radiator 10 with an electrically conductive layer 111 on one or both of the top and bottom surfaces as shown in Fig. 1A. An electrically conductive layer, as used throughout the specification, may be copper, gold, or any other electrically conductive material. The thermally conductive and electrically insulative radiator 10 may include a core 118 made from a ceramic, such as aluminum oxide ceramics, aluminum nitride ceramics, silicon carbide ceramics, etc. In the embodiment shown in Fig. 1A, an aluminum oxide ceramic plate 112 coated with copper on both surfaces is cut by means of mechanical or laser cutting to obtain a thermally conductive and electrically insulative radiator 10 with an electrically conductive layer 111 coated on both the top and bottom surfaces. The conductive layer 111 extends completely across the top and bottom surfaces to the edges thereof which can help reduce thermal stress on the radiator and prevent separation between the radiator and the dielectric layer.

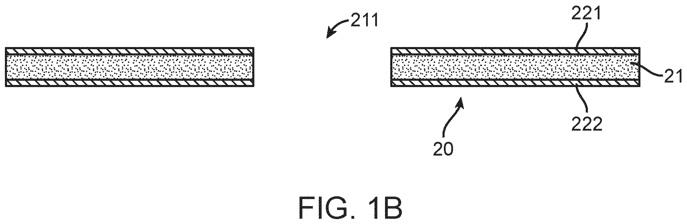

The method of manufacture described in Fig. 15 includes providing an organic resin plate having a first through hole 134. As shown in Fig. 1B, the organic resin plate 20 is coated with an electrically conductive layer 221, 222. The organic resin plate 20 has a first through hole 211 configured to receive the radiator 10. The resin plate 20 can be epoxy, fiber reinforced epoxy, FR4, etc. Although the organic resin plate shown in Fig. 1B is coated with an electrically conductive layer on both sides, it is also possible to have the coating on a single side as desired. In Fig. 1B, a double-sided FR4 copper coated plate 20 is provided, which comprises a dielectric layer 21 with first and second electrically conductive layers 221 and 222. The first through hole 211 is prepared by means of mechanical or laser drilling. The first electrically conductive layer 221 is an electrically conductive layer with no circuit pattern processed on its surface. In one embodiment, the first electrically conductive layer 221 has a thickness equal to that of the electrically conductive layer 111 which may be about 10Z. The second electrically conductive layer 222 is an electrically conductive layer with a circuit pattern (not shown) processed thereon according to methods known in the art (e.g. etching).

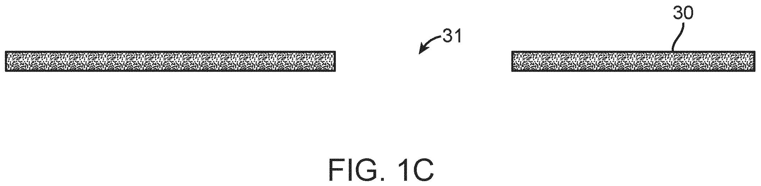

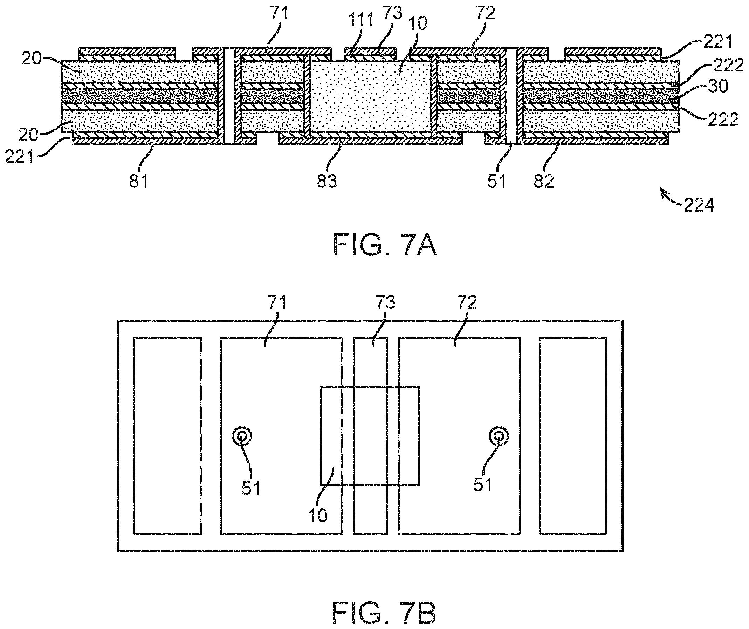

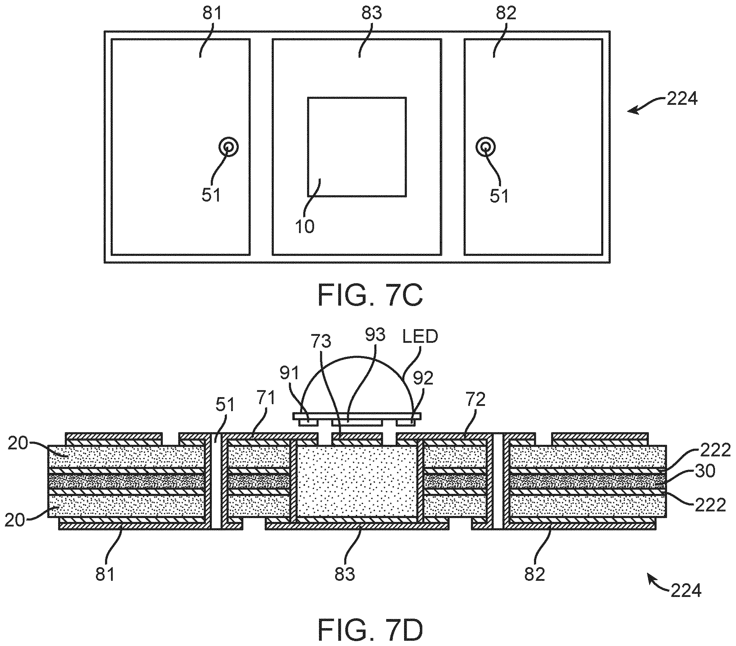

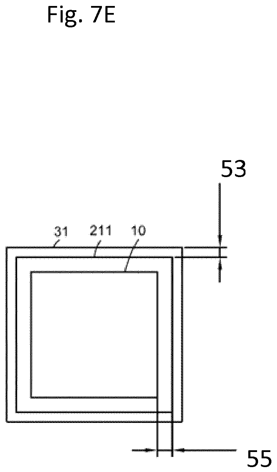

The method of Fig. 15 includes providing a semi-cured sheet having a second through hole in step 136. The PCB according to one embodiment of the invention includes the semi-cured sheet 30 (*e.g.* prepeg) having a second through hole 31 as best seen in Fig. 1C. The second through hole 31 desirably has dimensions similar to that of the first through hole 211 in the resin plate 20 to receive the radiator 10. In one embodiment, the second through hole 31 can prepared by means of mechanical or laser drilling on the semi-cured sheet 30. In other embodiments, the semi-cured sheet can be manufactured (in a mold, etc.) as already having the second through hole formed therein. The semi-cured sheet 30 can include epoxy which has not been fully cured. The relationship of the through holes and the radiator is depicted in Fig. 7E. The radiator 10 has a first length and width which may or may not be equal. The first through hole 211 is larger than the radiator by a first offset 55 to allow the radiator to be positioned within the dielectric layer 21. The second through hole 31 is shown as larger than the first through hole by a second offset 53. The first offset distance 55 is preferably between 0.1 and 0.2 mm and more preferably between 0.14 and 0.16 mm. The second offset 53 distance is preferably between 0.05 and 0.15 mm and more preferably between 0.09 and 0.11 mm.

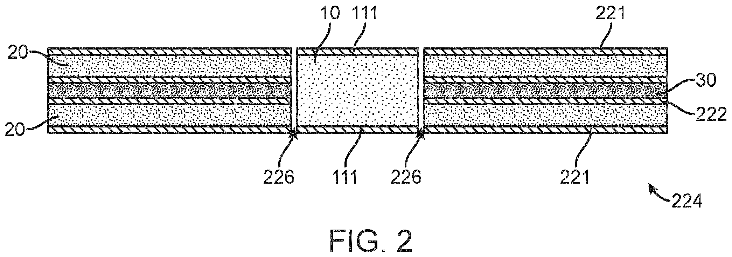

Fig. 15 describes a method of manufacture which includes stacking the resin plate and the semi-cured sheet, making them relatively fixed, and placing the radiator in the corresponding through holes 138. Fig. 2 depicts a resin plate 20 on each side of the semi-cured sheet 30. The first and second through holes 211, 31 are aligned and the resin plates 20 and semi-cured sheet 30 are temporarily or permanently bonded together (via bonding, gluing, welding, clamping, using connectors, etc.). The method further includes placing the radiator 10 inside the through holes to create a laminated PCB 224. As shown in Fig. 2, the electrically conductive layer 222 having the circuit pattern is positioned adjacent the semi-cured sheet 30 and is thus disposed inside the printed circuit board. In other words, all internal circuits of the PCB have been prepared prior to this step.

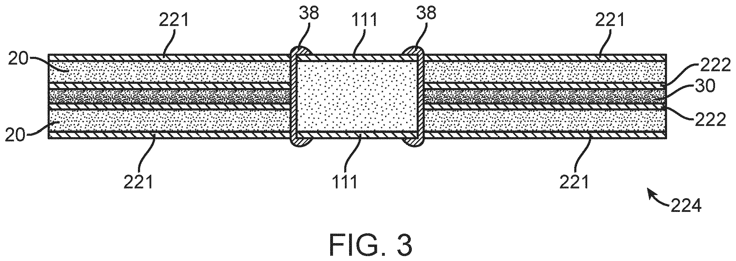

The method of Fig. 15 includes performing heat pressing on the laminated PCB 224 in step 140. Heat pressing includes applying pressure on opposite surfaces of the laminated PCB 224 while simultaneously heating the laminated PCB 224. The thickness of the laminated PCB 224 decreases under the action of the pressure, such that the surfaces of the electrically conductive layers 111 and 221 are substantially flush or nearly so. It is believed that heating the laminated PCB 224 allows the uncured epoxy in the semi-cured sheet 30 to fill the gap 226 (shown in Fig. 2) between the radiator 10 and the resin plates 20 and flow to the surfaces of the electrically conductive layers 111 and 221. The flowability of prepeg is positively related to its epoxy content. In some embodiments, the epoxy content of the prepeg disposed adjacent the resin plates can be about 60-75wt%, and more preferably, 65-70wt%. The relatively high flowability can help the prepeg to substantially or completely fill the gap 226. The radiator 10 and the plates 20 are fixedly connected as shown in Fig. 3 as a result of the heat pressing.

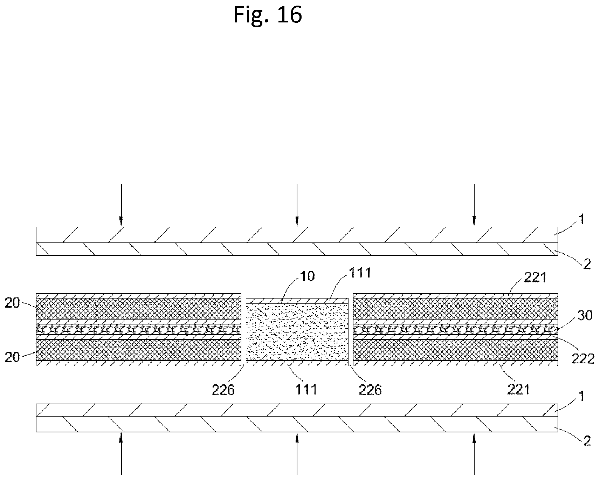

Fig. 16 illustrates one embodiment of a device which can be used in the heat pressing step. The device includes release film 2 is coupled to a flexible firm layer 1 (*e.g.* metal, plastic, Copper, Aluminum) having a thickness of about 0.05-0.3 mm. The film 2 and flexible firm layer 1 are disposed on both sides of the laminated PCB 224 with the release film 2 adjacent the PCB. The flexible firm layer 1 can improve the flatness of the laminated PCB 224 during the heat pressing such that the first electrically conductive layer 221 is co-planar with the electrically conductive layer 111 on the surface of the radiator 10 after the heat pressing step as shown in Fig. 2.

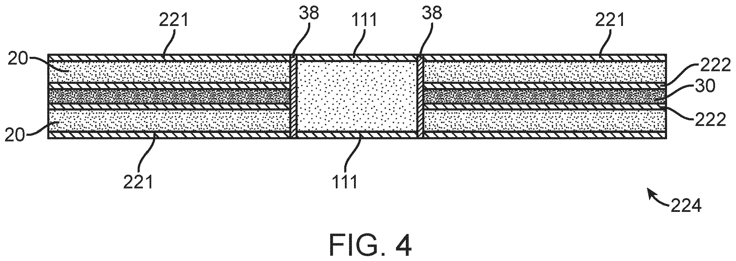

Excess resin 38 may flow to the plate surface during the heating step as shown in Fig. 3. Therefore, the method includes removing the cured resin 38 that overflows to the plate surface as described in step 142 of Fig. 15. In one embodiment, this can be achieved by grinding the cured resin 38 which is typically performed on the electrically conductive layers 111 and 221 at the same time. The grinding process can also help ensure that the surfaces of the cured resin 38 and the electrically conductive layers 111 and 221 are substantially flush, or nearly so, as shown in Fig. 4. In other embodiments, the cured resin could be removed by other methods (*e.g*. chemically).

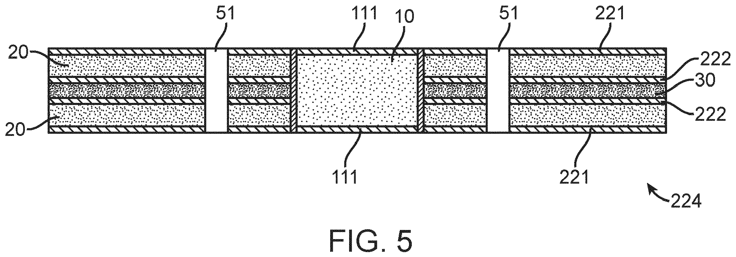

Through holes 51 are drilled through the laminated PCB 224 as part of the manufacturing process as described in step 144 of Fig. 15. The through holes 51 shown in Fig. 5 provide a path through which an electric connection can be established among all electrically conductive layers, as explained below.

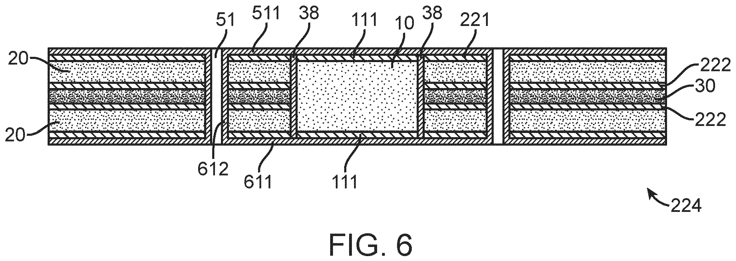

Fig. 15 describes a method which includes plating the board with an electrically conductive layer as shown in Fig. 6. The electrically conductive layers 511,611 are formed on the surfaces of the cured resin 38 as well as the electrically conductive layers 111 and 221. An electrically conductive layer 612 is also formed on the internal wall of the through holes 51. In one embodiment, the electrically conductive layers 611, 612 can be initially formed by chemical disposition of a base layer of copper. Electroplating can then be used to deposit additional copper onto the base layer. Of course, other conductive materials can be used in place of copper as previously discussed. The present invention is not intended to be limited to this process for creating the electrically conductive layer and any method of creating an electrically conductive layer known in the art may be used.

Surface circuits are fabricated in step 148 of Fig. 15. The circuits are fabricated on the laminated PCB 224 as shown in Figs. 7A-C. Typically, a pattern etching method (pattern processing) is used for fabricating surface circuits, which forms corresponding electrically conductive patterns on the top and bottom surfaces of the printed circuit board 224. As shown in Figs. 7A-C, pattern processing is performed on the electrically conductive layers 111, 221 and 511 on the top surface of the PCB to obtain a positive electrode bonding pad 71, a negative electrode bonding pad 72, and a heat conducting bonding pad 73. The bonding pads 71, 72, 73 all extend through the electrically conductive layers 221 and 611 to the surfaces of the radiator 10 and the dielectric layer 21 of the resin plate 20. Pattern processing is also performed on the electrically conductive layers on the bottom surface of the PCB to obtain a first terminal 81, a second terminal 82 and a heat dissipating pattern 83. The etching separating the heat dissipating pattern 83 from the first and second terminals 81, 82 extends to the surfaces of the radiator 10 and the dielectric layer 21.

The method includes coupling an LED to the PCB in step 149 of Fig. 15. As shown in Fig. 7D, the LED device comprises a positive electrode 91, a negative electrode 92, and a heat sink 93. The positive electrode 91, negative electrode 92, and heat sink 93 are coupled (*e.g*. via welding, epoxy) to the positive electrode bonding pad 71, negative electrode bonding pad 72, and the heat conducting bonding pad 73, respectively, thereby creating the LED module. Heat generated by the LED device can be dissipated through the heat conducting bonding pad 73, the radiator 10 and the heat dissipating pattern 83.

The method may further include coupling an LED drive circuit or control circuit element (not shown) to the bottom surface or top surface of the PCB. Such circuits may include driver, dimmer, voltage control, current control, color control, temperature protection circuits, etc. The method may also include the corresponding steps of arranging or forming such circuits on the PCB.

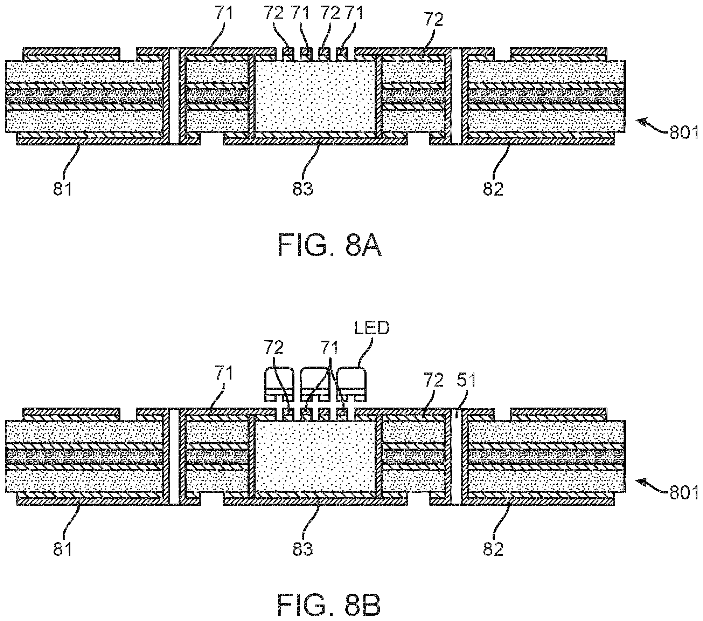

Fig. 8A illustrates another embodiment of a PCB 801. Some aspects of PCB 801 and its methods of manufacture are similar to that depicted in Figs. 1-7D, and only the differences between the this embodiment and that previously described are discussed. The PCB 801 of Figs. 8A-8B is depicted having a different electrically conductive pattern on the top surface compared to PCB 224. The pattern processing can be performed as previously described but the heat conducting bonding pad is omitted. Instead, multiple positive electrode bonding pads 71 and negative electrode bonding pads 72 are created. At least one of the positive electrode bonding pads 71 and the negative electrode bonding pads 72 extends to the surfaces of the radiator 10 and the dielectric layer 21. The positive electrodes and the negative electrodes of the LED devices may be coupled to the positive electrode bonding pads 71 and the negative electrode bonding pads 72, respectively, thereby obtaining the LED module, having multiple LEDs.

In other words, PCB 224 (Fig. 7D) is applicable for a LED device having three pins/electrodes, and PCB 801 (Fig. 8B) is applicable for a LED device having two pins/electrodes (e.g. a flip-chip LED chip).

In addition, the PCB in some or all embodiments of the present application are particularly applicable for LED devices mounted or encapsulated with a silicon substrate/chip. This is because silicon and ceramics have relatively similar heat expansion coefficients, and therefore, can avoid or reduce various structural and heat dissipation drawbacks as a result of the mismatch in heat expansion coefficients between an LED device and a printed circuit board. Thus, the product created according to the methods described herein has increased stability compared to previously known methods.

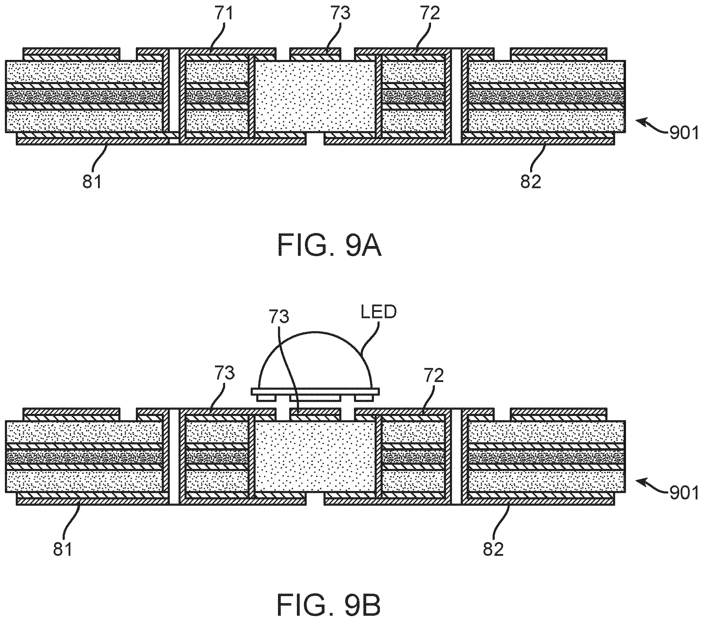

Another embodiment of a PCB is shown in Figs. 9A-9B. The electrically conductive pattern on the bottom surface of PCB 901 omits the heat dissipating pattern previously described. Instead, pattern processing is performed on the electrically conductive layers 111, 221 and 611 on the bottom surface of the PCB to obtain a first terminal 81 and a second terminal 82, wherein the first terminal 81 and the second terminal 82 extend to the surfaces of the radiator 10 and the dielectric layer 21.

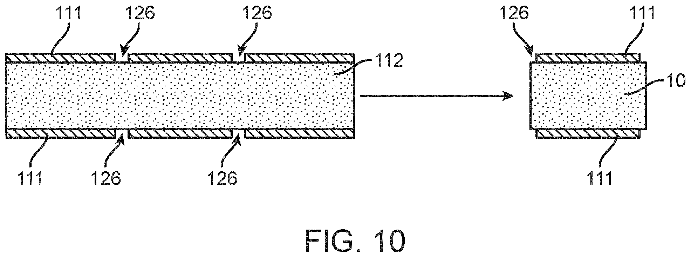

The conductive layer 111 of the radiator 10 can be etched prior to cutting the plate 112 as shown in Fig. 10. The etching forms a clearance 126 between the edge of the radiator 10 and the electrically conductive layer 111. Performing the etching step during preparation of the radiator also eliminates the formation of any burrs from the electrically conductive layer associated with a mechanical cutting process, thereby improving production efficiency.

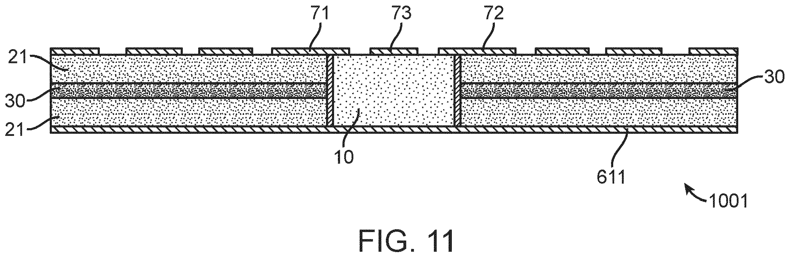

Fig. 11 illustrates a PCB 1001 having a radiator 10 and resin plate which are each formed without the electrically conductive layers 111, 221, 222 as described in previous embodiments. Instead, the dielectric layer 21 of the resin plate is coupled directly to the semi-cured sheet 30. The electrically conductive layer 611 is formed on the outer surface of the dielectric layers in accordance with the method previously described.

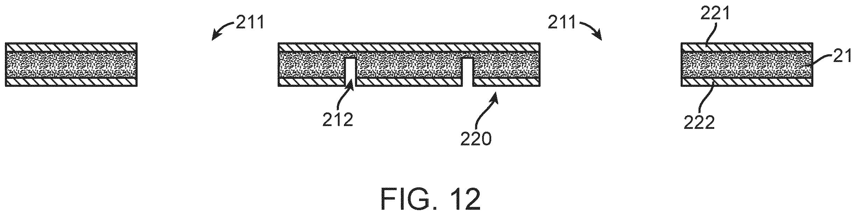

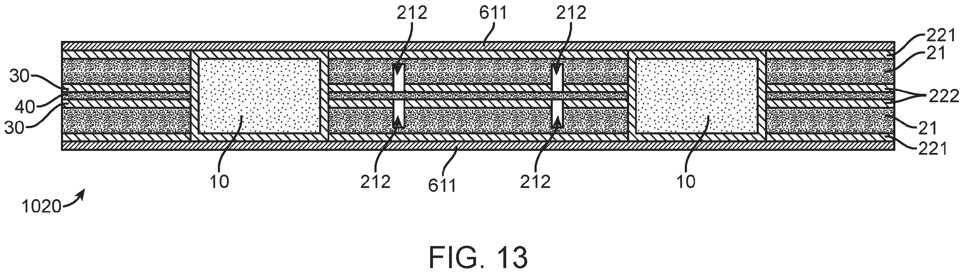

Another embodiment of a PCB is shown in Figs. 12-14 that combines both flexible and rigid parts. As shown in Fig. 13, the PCB 1020 includes a flexible circuit board 40 positioned between first and second semi-cured sheets 30. The flexible circuit board 40 has a third through hole which aligns with the first and second through holes in the resin plate and semi-cured sheet, respectively. The surface of the flexible circuit board 40 corresponding to the flexible portion 43 of the PCB 1020 is provided with a protective film (not shown).

Recesses 212 are formed in the resin plate 220 which form the boundaries of the flexible region of the PCB 1020 (*e.g.* by mechanical or laser cutting) as shown in Fig. 12. The recesses are typically formed during manufacture of the resin plate but could also be cut after the PCB is assembled. The resin plate 220 also includes a plurality of first through holes 211 to accommodate a plurality of radiators 10. A clearance hole in the semi-cured sheet 30 corresponding to the desired flexible portion 43 of the PCB 1020 is created prior to assembling the PCB.

The area corresponding to the desired flexible portion between the clearance holes in the semi cured sheet 30 is larger than the final flexible portion 43 to prevent or reduce epoxy flowing to the flexible portion 43. The prepeg adjacent the flexible circuit board can have less flowability than that of the prepeg adjacent the resin plates. For example, the epoxy content of the prepeg adjacent the flexible circuit board can be about 40-55wt%, and more preferably, about 45-50wt%. The relatively low flowability helps the prepeg to fill the gap 226 with reduced, or no prepeg flowing to the surface of the flexible portion 43.

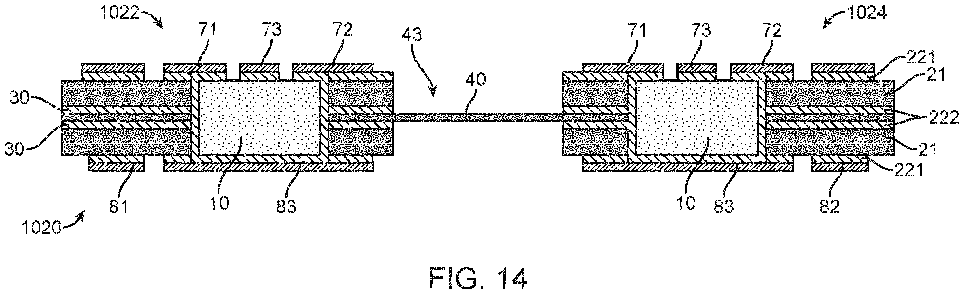

As shown in Figs. 14, the part of the rigid PCB corresponding to the flexible portion 43 is removed by means of mechanical or laser cutting. The resulting PCB 1020 has a first rigid portion 1022 and a second rigid portion 1024 with a flexible portion 43 separating the two. The first and second rigid portions 1022, 1024 a connected to one another by the flexible circuit board 40. The flexible PCB 1020 can have surface circuits formed thereon as previously described and an LED attached thereto.

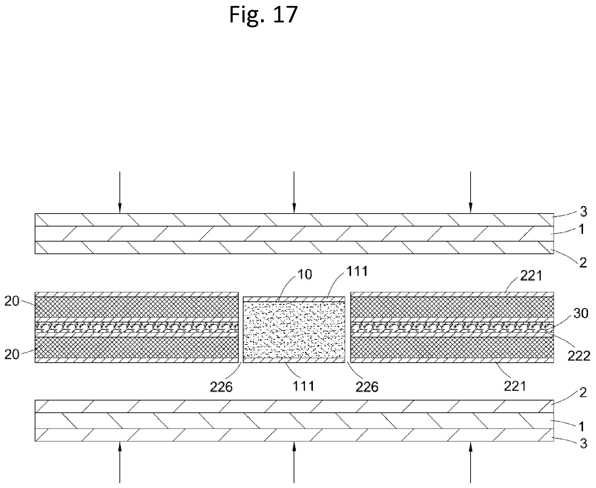

Another embodiment of a device which can be used in during the heat pressing step is illustrated in Fig. 17. In this embodiment, an elastomeric material layer 3 is further disposed at the outside of rigid layer 1. The elastomeric layer 3 may be a silicone rubber or similar material.

Another embodiment of the PCB may include one or more layers of flexible PCB and one or more layers of rigid PCB. Different prepegs can be used in such an embodiment. For example, prepeg adjacent the flexible PCB can have a lower flowability than that of the prepeg disposed adjacent the organic resin plates.

Although the invention herein has been described with reference to particular embodiments, it is to be understood that these embodiments are merely illustrative of the principles and applications of the present invention. It is therefore to be understood that numerous modifications may be made to the illustrative embodiments and that other arrangements may be devised without departing from the scope of the present invention as defined by the appended claims.

## Claims

1. A printed circuit board having a top surface and a bottom surface comprising:
a radiator (10) having an electrically insulated core (118) and a first electrically conductive layer (111) formed on a top and bottom surface of the electrically insulated core (118);
a substrate having a second electrically conductive layer (221) formed on a top and bottom surface of the substrate;
a plurality of electrode bonding pads (71, 72) on the top surface of the printed circuit board, wherein each of the electrode bonding pads (71, 72) comprises a third electrically conductive layer (511) extending from a surface of the second electrically conductive layer (221) to a surface of the first electrically conductive layer (111), the plurality of electrode bonding pads comprising a positive electrode bonding pad (71) and a negative electrode bonding pad (72); and
a fourth electrically conductive layer (611) on the bottom surface of the printed circuit board, wherein the fourth electrically conductive layer (611) extends from a surface of the second electrically conductive layer (221) to a surface of the first electrically conductive layer (111).

2. The printed circuit board of claim 1, comprising a plurality of terminals (81, 82) on the bottom surface, each electrically connected to at least one of the plurality of electrode bonding pads.

3. The printed circuit board of claim 1, comprising a heat dissipater (83) on the bottom surface coupled to the radiator and the substrate.

4. The printed circuit board of claim 1, further comprising:
a second printed circuit board (1024) having a top surface and a bottom surface, a radiator, a substrate, a plurality of electrode bonding pads on the top surface, a plurality of terminals on the bottom surface each electrically connected to at least one of the plurality of electrode bonding pads, and a heat dissipater on the bottom surface coupled to the radiator and the substrate; and
a flexible member (40) between the top and bottom surfaces of each of the printed circuit boards, the flexible member linking the printed circuit boards.

5. The printed circuit board of claim 4, wherein the printed circuit boards are separated from each other by a distance and linked by the flexible member.

6. The printed circuit board of claim 1, wherein the substrate comprises a semi-cured sheet (30) between a plurality of resin plates (112, 220).

7. A method of manufacturing a flexible printed circuit board comprising:
providing a plurality of radiators (10) having an electrically insulated core (118) and a first electrically conductive layer (111) formed on a top and bottom surface of the electrically insulated core (118);
providing a substrate including a plurality of through holes (211, 31), a flexible member (40), and a second electrically conductive layer (221) formed on a top and bottom surface of the substrate;
inserting the plurality of radiators in the plurality of through holes;
heat pressing the substrate and radiators;
depositing a third electrically conductive layer (511) on the top surface of the flexible printed circuit board;
depositing a fourth electrically conductive layer (611) on the bottom surface of the flexible printed circuit board, wherein each of the third and fourth electrically conductive layers extends from a surface of the second electrically conductive layer to a surface of the first electrically conductive layer; and
removing a portion (43) of the substrate between the radiators;
wherein the flexible printed circuit board is flexible in a region where the portion of substrate was removed.

8. The method of claim 7, wherein the substrate includes a resin plate (112, 220) having a plurality of through holes (211) extending through the resin plate and a plurality of recesses (212) extending partially through the resin plate, and a semi-cured sheet (30) having a plurality of through holes and a clearance hole, and providing the substrate includes:
coupling the resin plate, semi-cured sheet, and flexible member together such that the plurality of through holes align and each of the plurality of recesses align with an edge of the clearance hole.

9. The method of claim 8, wherein the method includes removing from a surface of the flexible printed circuit board resin that flows to said surface.

10. The method of claim 7, further comprising forming a plurality of electrode bonding pads (71, 72) and a heat conducting bonding pad (73) on the top surface of the flexible printed circuit board.

11. The method of claim 7, further comprising forming a plurality of terminals (81, 82) and a heat dissipating pattern (83) on the bottom surface of the flexible printed circuit board.

12. The method of claim 11, wherein the heat dissipating pattern covers at least a portion of one of the plurality of radiators and the substrate.

13. The method of claim 7, further comprising coupling an LED (LED) to the flexible printed circuit board.

14. A method of manufacturing a printed circuit board comprising:
forming a first electrically conductive layer (111, 222) on a top and a bottom surface of an electrically insulated core (118);
cutting the electrically insulated core, thereby creating a radiator (10);
providing a substrate having a through hole (211, 31) and a second electrically conductive layer (221) formed in a top and a bottom surface of the substrate;
inserting the radiator into the through hole ;
heat pressing the radiator and substrate;
forming a third electrically conductive layer (511) on the top surface of the printed circuit board;
forming a fourth electrically conductive layer (611) on the bottom surface of the printed circuit board, wherein each of the third and fourth electrically conductive layers extends from a surface of the second electrically conductive layer to a surface of the first electrically conductive layer; and
creating a plurality of electrode bonding pads (71, 72) on the top surface of the printed circuit board.

## Patentansprüche

1. Leiterplatte, die eine obere Fläche und eine untere Fläche aufweist, umfassend:
einen Kühlkörper (10), der einen elektrisch isolierten Kern (118) und eine erste elektrisch leitende Schicht (111) aufweist, die auf einer oberen und unteren Fläche des elektrisch isolierten Kerns (118) gebildet ist;
ein Substrat, das eine zweite elektrisch leitende Schicht (221) aufweist, die auf einer oberen und unteren Fläche des Substrats gebildet ist;
eine Vielzahl von Elektroden-Bondpads (71, 72) auf der oberen Fläche der Leiterplatte, wobei jedes der Elektroden-Bondpads (71, 72) eine dritte elektrisch leitende Schicht (511) umfasst, die sich von einer Fläche der zweiten elektrisch leitenden Schicht (221) zu einer Fläche der ersten elektrisch leitenden Schicht (111) erstreckt, wobei die Vielzahl von Elektroden-Bondpads ein positives Elektroden-Bondpad (71) und ein negatives Elektroden-Bondpad (72) umfasst; und
eine vierte elektrisch leitende Schicht (611) auf der unteren Fläche der Leiterplatte, wobei sich die vierte elektrisch leitende Schicht (611) von einer Fläche der zweiten elektrisch leitenden Schicht (221) zu einer Fläche der ersten elektrisch leitenden Schicht (111) erstreckt.

2. Leiterplatte nach Anspruch 1, die eine Vielzahl von Anschlüssen (81, 82) auf der unteren Fläche umfasst, die jeder elektrisch mit mindestens einem aus der Vielzahl von Elektroden-Bondpads verbunden sind.

3. Leiterplatte nach Anspruch 1, die auf der unteren Fläche einen Wärmeableiter (83) umfasst, der mit dem Kühlkörper und dem Substrat gekoppelt ist.

4. Leiterplatte nach Anspruch 1, weiter umfassend:
eine zweite Leiterplatte (1024), die eine obere Fläche und eine untere Fläche, einen Kühlkörper, ein Substrat, eine Vielzahl von Elektroden-Bondpads auf der oberen Fläche, eine Vielzahl von Anschlüssen auf der unteren Fläche, die jeder elektrisch mit mindestens einem aus der Vielzahl von Elektroden-Bondpads verbunden sind, und einen Wärmeableiter auf der unteren Fläche aufweist, der mit dem Kühlkörper und dem Substrat gekoppelt ist; und
ein flexibles Glied (40) zwischen der oberen und unteren Fläche jeder der Leiterplatten, wobei das flexible Glied die Leiterplatten miteinander verbindet.

5. Leiterplatte nach Anspruch 4, wobei die Leiterplatten um einen Abstand voneinander getrennt und über das flexible Glied miteinander verbunden sind.

6. Leiterplatte nach Anspruch 1, wobei das Substrat eine halbgehärtete Folie (30) zwischen einer Vielzahl von Harzplatten (112, 220) umfasst.

7. Verfahren zur Herstellung einer flexiblen Leiterplatte, umfassend:
Bereitstellen einer Vielzahl von Kühlkörpern (10), die einen elektrisch isolierten Kern (118) und eine erste elektrisch leitende Schicht (111) aufweisen, welche auf einer oberen und unteren Fläche des elektrisch isolierten Kerns (118) gebildet ist;
Bereitstellen eines Substrats, das eine Vielzahl von Durchgangslöchern (211, 31), ein flexibles Glied (40) und eine zweite elektrisch leitende Schicht (221) einschließt, welche auf einer oberen und unteren Fläche des Substrats gebildet ist;
Einfügen der Vielzahl von Kühlkörpern in die Vielzahl von Durchgangslöchern;
Heißverpressen des Substrats und der Kühlkörper;
Abscheiden einer dritten elektrisch leitenden Schicht (511) auf der oberen Fläche der flexiblen Leiterplatte;
Abscheiden einer vierten elektrisch leitenden Schicht (611) auf der unteren Fläche der flexiblen Leiterplatte, wobei sich jede aus der dritten und vierten elektrisch leitenden Schicht von einer Fläche der zweiten elektrisch leitenden Schicht zu einer Fläche der ersten elektrisch leitenden Schicht erstreckt; und
Entfernen eines Abschnitts (43) des Substrats zwischen den Kühlkörpern;
wobei die flexible Leiterplatte in einem Bereich flexibel ist, in dem der Substratabschnitt entfernt wurde.

8. Verfahren nach Anspruch 7, wobei das Substrat eine Harzplatte (112, 220), die eine Vielzahl von Durchgangslöchern (211), welche sich durch die Harzplatte hindurch erstrecken, und eine Vielzahl von Vertiefungen (212) aufweist, die sich teilweise durch die Harzplatte erstrecken, und eine halbgehärtete Folie (30) einschließt, die eine Vielzahl von Durchgangslöchern und ein Distanzloch aufweist, und das Bereitstellen des Substrats einschließt:
Koppeln der Harzplatte, der halbgehärteten Folie und des flexiblen Glieds derart miteinander, dass die Vielzahl von Durchgangslöchern fluchten und jede aus der Vielzahl von Vertiefungen mit einer Kante des Distanzlochs fluchtet.

9. Verfahren nach Anspruch 8, wobei das Verfahren das Entfernen von Harz, das zu der Fläche fließt, von einer Fläche der flexiblen Leiterplatte einschließt.

10. Verfahren nach Anspruch 7, weiter das Bilden einer Vielzahl von Elektroden-Bondpads (71, 72) und eines wärmeleitenden Bondpads (73) auf der oberen Fläche der flexiblen Leiterplatte umfassend.

11. Verfahren nach Anspruch 7, weiter das Bilden einer Vielzahl von Anschlüssen (81, 82) und eines wärmeableitenden Musters (83) auf der unteren Fläche der flexiblen Leiterplatte umfassend.

12. Verfahren nach Anspruch 11, wobei das wärmeableitende Muster mindestens einen Abschnitt von einem aus der Vielzahl von Kühlkörpern und dem Substrat bedeckt.

13. Verfahren nach Anspruch 7, weiter das Koppeln einer LED (LED) mit der flexiblen Leiterplatte umfassend.

14. Verfahren zur Herstellung einer Leiterplatte, umfassend:
Bilden einer ersten elektrisch leitenden Schicht (111, 222) auf einer oberen und einer unteren Fläche eines elektrisch isolierten Kerns (118);
Zuschneiden des elektrisch isolierten Kerns, wodurch ein Kühlkörper (10) erzeugt wird;
Bereitstellen eines Substrats, das ein Durchgangsloch (211, 31) und eine zweite elektrisch leitende Schicht (221) aufweist, die in einer oberen und einer unteren Fläche des Substrats gebildet ist;
Einfügen des Kühlkörpers in das Durchgangsloch;
Heißverpressen des Kühlkörpers und Substrats;
Bilden einer dritten elektrisch leitenden Schicht (511) auf der oberen Fläche der Leiterplatte;
Bilden einer vierten elektrisch leitenden Schicht (611) auf der unteren Fläche der Leiterplatte, wobei sich jede aus der dritten und vierten elektrisch leitenden Schicht von einer Fläche der zweiten elektrisch leitenden Schicht zu einer Fläche der ersten elektrisch leitenden Schicht erstreckt; und
Erzeugen einer Vielzahl von Elektroden-Bondpads (71, 72) auf der oberen Fläche der Leiterplatte.

## Revendications

1. Carte de circuit imprimé ayant une surface supérieure et une surface inférieure comprenant :
un radiateur (10) ayant une partie centrale isolée électriquement (118) et une première couche électriquement conductrice (111) formée sur une surface supérieure et inférieure de la partie centrale isolée électriquement (118) ;
un substrat ayant une deuxième couche électriquement conductrice (221) formée sur une surface supérieure et inférieure du substrat ;
une pluralité de blocs de contact d'électrode (71, 72) sur la surface supérieure de la carte de circuit imprimé, dans laquelle chacune des blocs de contact d'électrode (71, 72) comprend une troisième couche électriquement conductrice (511) s'étendant à partir d'une surface de la deuxième couche électriquement conductrice (221) jusqu'à une surface de la première couche électriquement conductrice (111), la pluralité de blocs de contact d'électrode comprenant un bloc de contact d'électrode positif (71) et un bloc de contact d'électrode négatif (72) ; et
une quatrième couche électriquement conductrice (611) sur la surface inférieure de la carte de circuit imprimé, dans laquelle la quatrième couche électriquement conductrice (611) s'étend à partir d'une surface de la deuxième couche électriquement conductrice (221) jusqu'à une surface de la première couche électriquement conductrice (111).

2. Carte de circuit imprimé de la revendication 1, comprenant une pluralité de bornes (81, 82) sur la surface inférieure, chacune étant connectée électriquement à au moins une parmi la pluralité de blocs de contact d'électrode.

3. Carte de circuit imprimé de la revendication 1, comprenant un dissipateur thermique (83) sur la surface inférieure couplé au radiateur et au substrat.

4. Carte de circuit imprimé de la revendication 1, comprenant en outre :
une seconde carte de circuit imprimé (1024) ayant une surface supérieure et une surface inférieure, un radiateur, un substrat, une pluralité de blocs de contact d'électrode sur la surface supérieure, une pluralité de bornes sur la surface inférieure chacune étant connectée électriquement à au moins une parmi la pluralité de blocs de contact d'électrode, et un dissipateur thermique sur la surface inférieure couplé au radiateur et au substrat ; et
un élément souple (40) entre les surfaces supérieure et inférieure de chacune des cartes de circuit imprimé, l'élément souple reliant les cartes de circuit imprimé.

5. Carte de circuit imprimé de la revendication 4, dans laquelle les cartes de circuit imprimé sont séparées l'une de l'autre par une distance et reliées par l'élément souple.

6. Carte de circuit imprimé de la revendication 1, dans laquelle le substrat comprend une feuille semi-durcie (30) entre une pluralité de plaques en résine (112, 220).

7. Méthode de fabrication d'une carte de circuit imprimé souple comprenant :
la fourniture d'une pluralité de radiateurs (10) ayant une partie centrale isolée électriquement (118) et une première couche électriquement conductrice (111) formée sur une surface supérieure et inférieure de la partie centrale isolée électriquement (118) ;
la fourniture d'un substrat incluant une pluralité de trous débouchants (211, 31), un élément souple (40), et une deuxième couche électriquement conductrice (221) formée sur une surface supérieure et inférieure du substrat ;
l'insertion de la pluralité de radiateurs dans la pluralité de trous débouchants ;
le pressage à chaud du substrat et des radiateurs ;
le dépôt d'une troisième couche électriquement conductrice (511) sur la surface supérieure de la carte de circuit imprimé souple ;
le dépôt d'une quatrième couche électriquement conductrice (611) sur la surface inférieure de la carte de circuit imprimé souple, dans laquelle chacune des troisième et quatrième couches électriquement conductrices s'étend à partir d'une surface de la deuxième couche électriquement conductrice jusqu'à une surface de la première couche électriquement conductrice ; et
le retrait d'une partie (43) du substrat entre les radiateurs ;
dans laquelle la carte de circuit imprimé souple est souple dans une région où la partie de substrat a été retirée.

8. Méthode de la revendication 7, dans laquelle le substrat inclut une plaque en résine (112, 220) ayant une pluralité de trous débouchants (211) s'étendant à travers la plaque en résine et une pluralité d'évidements (212) s'étendant partiellement à travers la plaque en résine, et une feuille semi-durcie (30) ayant une pluralité de trous débouchants et un trou enfoncé, et la fourniture du substrat inclut :
le couplage de la plaque en résine, de la feuille semi-durcie, et de l'élément souple ensemble de telle sorte que la pluralité de trous débouchants s'alignent et chacun de la pluralité d'évidements s'aligne sur un bord du trou enfoncé.

9. Méthode de la revendication 8, dans laquelle la méthode inclut le retrait à partir d'une surface de la carte de circuit imprimé souple d'une résine qui coule vers ladite surface.

10. Méthode de la revendication 7, comprenant en outre la formation d'une pluralité de blocs de contact d'électrode (71, 72) et d'un bloc de contact thermoconducteur (73) sur la surface supérieure de la carte de circuit imprimé souple.

11. Méthode de la revendication 7, comprenant en outre la formation d'une pluralité de bornes (81, 82) et d'un motif de dissipation thermique (83) sur la surface inférieure de la carte de circuit imprimé souple.

12. Méthode de la revendication 11, dans laquelle le motif de dissipation thermique recouvre au moins une partie d'un parmi la pluralité de radiateurs et le substrat.

13. Méthode de la revendication 7, comprenant en outre le couplage d'une LED (LED) à la carte de circuit imprimé souple.

14. Méthode de fabrication d'une carte de circuit imprimé comprenant :
la formation d'une première couche électriquement conductrice (111, 222) sur une surface supérieure et inférieure d'une partie centrale isolée électriquement (118) ;
la découpe de la partie centrale isolée électriquement, créant ainsi un radiateur (10) ;
la fourniture d'un substrat ayant un trou débouchant (211, 31) et d'une deuxième couche électriquement conductrice (221) formée dans une surface supérieure et inférieure du substrat ;
l'insertion du radiateur dans le trou débouchant ;
le pressage à chaud du radiateur et du substrat ;
la formation d'une troisième couche électriquement conductrice (511) sur la surface supérieure de la carte de circuit imprimé ;
la formation d'une quatrième couche électriquement conductrice (611) sur la surface inférieure de la carte de circuit imprimé, dans laquelle chacune des troisième et quatrième couches électriquement conductrices s'étend à partir d'une surface de la deuxième couche électriquement conductrice jusqu'à une surface de la première couche électriquement conductrice ; et
la création d'une pluralité de blocs de contact d'électrode (71, 72) sur la surface supérieure de la carte de circuit imprimé.
